(19)

**Europäisches Patentamt**
**European Patent Office**
**Office européen des brevets**

(11) **EP 4 264 373 B1**

(12) **EUROPEAN PATENT SPECIFICATION**

(45) Date of publication and mention
of the grant of the patent:
**29.10.2025  Bulletin 2025/44**

(21) Application number: **21819114.6**

(22) Date of filing: **24.11.2021**

(51) International Patent Classification (IPC):
**G03F 7/00** $^{(2006.01)}$    **G06T 7/00** $^{(2017.01)}$
**G06T 7/33** $^{(2017.01)}$

(52) Cooperative Patent Classification (CPC):
**G03F 7/7065; G06T 7/001; G06T 7/33;**
G06T 2207/10061; G06T 2207/30148;
H01J 2237/221; H01J 2237/2817

(86) International application number:
**PCT/EP2021/082773**

(87) International publication number:
**WO 2022/128374 (23.06.2022 Gazette 2022/25)**

(54) **TOPOLOGY-BASED IMAGE RENDERING IN CHARGED-PARTICLE BEAM INSPECTION SYSTEMS**

TOPOLOGIEBASIERTE BILDWIEDERGABE IN INSPEKTIONSSYSTEMEN MIT GELADENEN TEILCHENSTRAHLEN

RENDU D'IMAGE FONDÉ SUR LA TOPOLOGIE DANS DES SYSTÈMES D'INSPECTION À FAISCEAU DE PARTICULES CHARGÉES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.12.2020   US 202063126434 P**

(43) Date of publication of application:
**25.10.2023   Bulletin 2023/43**

(73) Proprietor: **ASML Netherlands B.V.**
**5500 AH Veldhoven (NL)**

(72) Inventors:
• **LIANG, Haoyi**
**San Jose, CA 95134 (US)**
• **MA, Bing**
**San Jose, California 95134 (US)**
• **CHEN, Zhichao**
**San Jose, California 95134 (US)**
• **KEA, Marc, Jurian**
**San Jose, California 95134 (US)**

(74) Representative: **ASML Netherlands B.V.**
**Corporate Intellectual Property**
**P.O. Box 324**
**5500 AH Veldhoven (NL)**

(56) References cited:
**US-A1- 2007 230 770     US-A1- 2008 298 719**
**US-A1- 2015 086 127     US-A1- 2018 330 511**

• **ALTUNBASAK Y ET AL: "A maximum a posteriori estimator for high resolution video reconstruction from MPEG video", IMAGE PROCESSING, 2000. PROCEEDINGS. 2000 INTERNATIONAL CONFERENCE ON SEPTEMBER 10-13, 2000, IEEE, PISCATAWAY, NJ, USA, 10 September 2000 (2000-09-10), pages 649 - 652vol.2, XP031534537, ISBN: 978-0-7803-6297-0**
• **TAE HYUN KIM ET AL: "Dynamic Scene Deblurring using a Locally Adaptive Linear Blur Model", ARXIV.ORG, CORNELL UNIVERSITY LIBRARY, 201 OLIN LIBRARY CORNELL UNIVERSITY ITHACA, NY 14853, 14 March 2016 (2016-03-14), XP080689495**

EP 4 264 373 B1

## EP 4 264 373 B1

**Description**

<u>TECHNICAL FIELD</u>

The embodiments provided herein relate to image-rendering techniques, and more particularly to systems and methods of rendering images for alignment with inspection images obtained from a charged-particle beam inspection apparatus.

<u>BACKGROUND</u>

In manufacturing processes of integrated circuits (ICs), unfinished or finished circuit components are inspected to ensure that they are manufactured according to design and are free of defects. Inspection systems utilizing optical microscopes or charged particle (e.g., electron) beam microscopes, such as a scanning electron microscope (SEM) can be employed. As feature sizes continue to shrink well past the optical resolution limit, the fabrication and back-end analyses get more complex. Specifically, the control of edge placement error (EPE) in playing a key role in patterning of advanced technology node in the semiconductor industry. To obtain high throughput and yield in 3D NANDs and FinFET ICs, EPE is expected to be 0.5 nm or less, requiring high precision and repeatability in feature placement and alignment. A reliable measurement of EPE plays a vital role in quality control, throughput, and yield learning. Although existing die-to-database (D2DB) alignment techniques, including edge-based and correlation-based techniques may offer high throughput, however, the high variance of correlation-based alignment and poor repeatability render the technique inadequate for alignment of features in complex device structures such as DRAM, or FinFETs.
US2018330511A1, US2008298719A1, US2007230770A1 and US2015086127A1 disclose image alignment techniques. ALTUNBASAK Y ET AL: "A maximum a posteriori estimator for high resolution video reconstruction from MPEG video", IMAGE PROCESSING, 2000, PROCEEDINGS IEEE, 10 September 2000 (2000-09-10), pages 649-652 discloses techniques for producing a high-quality still image from archived MPEG video. TAE HYUN KIM ET AL: "Dynamic Scene Deblurring using a Locally Adaptive Linear Blur Model", ARXIV.ORG, 14 March 2016 (2016-03-14), discloses deblurring methods.

<u>SUMMARY</u>

The embodiments provided herein disclose systems and methods of image alignment, particularly alignment of inspection images with reference images or rendered images for wafer metrology and inspection.
One aspect of the present invention is directed to an image alignment method, as defined in claim 1.
Another aspect of the present invention is directed to an image alignment system, as defined in claim 12.
Other advantages of the embodiments of the present disclosure will become apparent from the following description taken in conjunction with the accompanying drawings wherein are set forth, by way of illustration and example, certain embodiments of the present invention.

<u>BRIEF DESCRIPTION OF FIGURES</u>

Fig. 1 is a schematic diagram illustrating an exemplary electron beam inspection (EBI) system, consistent with embodiments of the present disclosure.
Fig. 2 is a schematic diagram illustrating an exemplary electron beam tool that can be a part of the exemplary electron beam inspection system of Fig. 1, consistent with embodiments of the present disclosure.
Fig. 3 illustrates an exemplary metrology system including an image alignment module, consistent with embodiments of the present disclosure.
Fig. 4A illustrates an exemplary flowchart of an image alignment method performed by the metrology system of Fig. 3, consistent with embodiments of the present disclosure.
Fig. 4B illustrates an exemplary method to align inspection images based on parameter selection for image rendering, consistent with embodiments of the present disclosure.
Fig. 5 is a process flowchart representing an exemplary method of image alignment, consistent with embodiments of the present disclosure.

<u>DETAILED DESCRIPTION</u>

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations. Instead, they are merely examples of apparatuses and methods consistent with aspects related to the disclosed embodiments as recited in the appended claims. For example, although some embodiments are described in the context of utilizing electron beams, the disclosure is not so limited. Other types of charged particle beams may be similarly applied. Furthermore, other imaging systems may be used, such as optical imaging, photo detection, x-ray detection, etc.

Electronic devices are constructed of circuits formed on a piece of silicon called a substrate. Many circuits may be formed together on the same piece of silicon and are called integrated circuits or ICs. The size of these circuits has decreased dramatically so that many more of them can fit on the substrate. For example, an IC chip in a smart phone can be as small as a thumbnail and yet may include over 2 billion transistors, the size of each transistor being less than 1/1000th the size of a human hair.

Making these extremely small ICs is a complex, time-consuming, and expensive process, often involving hundreds of individual steps. Errors in even one step have the potential to result in defects in the finished IC, thereby rendering it useless. Thus, one goal of the manufacturing process is to avoid such defects to maximize the number of functional ICs made in the process, that is, to improve the overall yield of the process.

One component of improving yield is monitoring the chip making process to ensure that it is producing a sufficient number of functional integrated circuits. One way to monitor the process is to inspect the chip circuit structures at various stages of their formation. Inspection can be carried out using a scanning electron microscope (SEM). An SEM can be used to image these extremely small structures, in effect, taking a "picture" of the structures. The image can be used to determine if the structure was formed properly and also if it was formed in the proper location. If the structure is defective, then the process can be adjusted so the defect is less likely to recur.

IC design layouts, before being transferred to a wafer through fabrication processes, are stored in binary file formats such as Graphic Design System (GDS or GDSII) representing planar geometries, text labels, etc. The data can be used to reconstruct or "render" pixel-based images which can be used for visualization, wafer inspection, or other metrology applications. In the drive toward sub-10 nm semiconductor devices, although high-speed patterning technologies are beneficial, however, they can introduce undesirable and hard-to-detect defects. Die-to-Database (D2DB) inspection techniques are commonly used for high-speed inspection, which compares an inspection image with a design layout.

Some of the existing GDS rendering methods include assigning pixels different intensity values based on their location with reference to the GDS pattern. While this method may provide accurate rendering of the contours and shapes in GDS designs, it suffers from drawbacks such as off-center shifts, high misalignment rates, among other issues. Alternatively, GDS images can be rendered based on pre-defined rules and learned models for specific images to produce simulated inspection images. However, doing so may be resource-intensive and less user-friendly. Therefore, further improvements in rendering methods that provide a precise and repeatable template for D2DB alignment may be desirable to mitigate alignment errors and large EPEs.

Some embodiments of the present disclosure are directed to apparatuses and methods of image alignment. The alignment method may include obtaining information associated with a reference GDS image corresponding to an inspection image of a feature or a sample captured by, for example, an electron beam apparatus. The method may further include rendering the reference GDS image based on rendering parameters and modifying the rendered reference GDS image based on a topology characteristic such that the topology of the rendered image is substantially preserved. The method may further include aligning the inspection image with the reference GDS image based on an alignment between the inspection image and the modified rendered image.

Relative dimensions of components in drawings may be exaggerated for clarity. Within the following description of drawings, the same or like reference numbers refer to the same or like components or entities, and only the differences with respect to the individual embodiments are described. As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

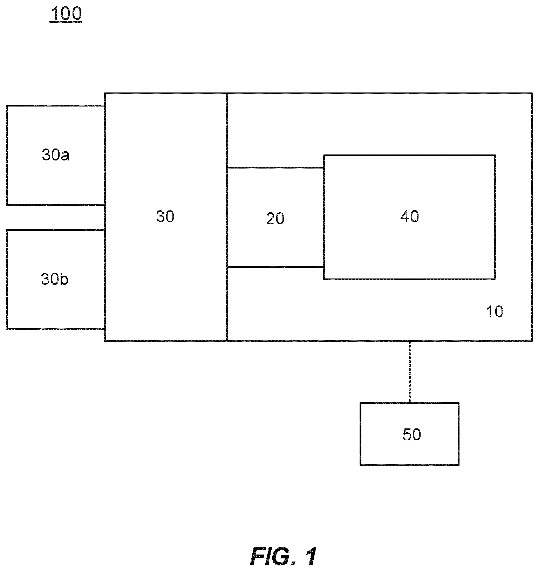

Reference is now made to Fig. 1, which illustrates an exemplary electron beam inspection (EBI) system 100 consistent with embodiments of the present disclosure. As shown in Fig. 1, charged particle beam inspection system 100 includes a main chamber 10, a load-lock chamber 20, an electron beam tool 40, and an equipment front end module (EFEM) 30. Electron beam tool 40 is located within main chamber 10. While the description and drawings are directed to an electron beam, it is appreciated that the embodiments are not used to limit the present disclosure to specific charged particles.

EFEM 30 includes a first loading port 30a and a second loading port 30b. EFEM 30 may include additional loading port(s). First loading port 30a and second loading port 30b receive wafer front opening unified pods (FOUPs) that contain wafers (e.g., semiconductor wafers or wafers made of other material(s)) or samples to be inspected (wafers and samples are collectively referred to as "wafers" hereafter). One or more robot arms (not shown) in EFEM 30 transport the wafers to load-lock chamber 20.

Load-lock chamber 20 is connected to a load/lock vacuum pump system (not shown), which removes gas molecules in load-lock chamber 20 to reach a first pressure below the atmospheric pressure. After reaching the first pressure, one or more robot arms (not shown) transport the wafer from load-lock chamber 20 to main chamber 10. Main chamber 10 is connected to a main chamber vacuum pump system (not shown), which removes gas molecules in main chamber 10 to reach a second pressure below the first pressure. After reaching the second pressure, the wafer is subject to inspection by electron beam tool 40. In some embodiments, electron beam tool 40 may comprise a single-beam inspection tool. In other embodiments, electron beam tool 40 may comprise a multibeam inspection tool.

Controller 50 may be electronically connected to electron beam tool 40 and may be electronically connected to other components as well. Controller 50 may be a computer configured to execute various controls of charged particle beam inspection system 100. Controller 50 may also include processing circuitry configured to execute various signal and image processing functions. While controller 50 is shown in Fig. 1 as being outside of the structure that includes main chamber 10, load-lock chamber 20, and EFEM 30, it is appreciated that controller 50 can be part of the structure.

While the present disclosure provides examples of main chamber 10 housing an electron beam inspection system, it should be noted that aspects of the disclosure in their broadest sense, are not limited to a chamber housing an electron beam inspection system. Rather, it is appreciated that the foregoing principles may be applied to other chambers as well.

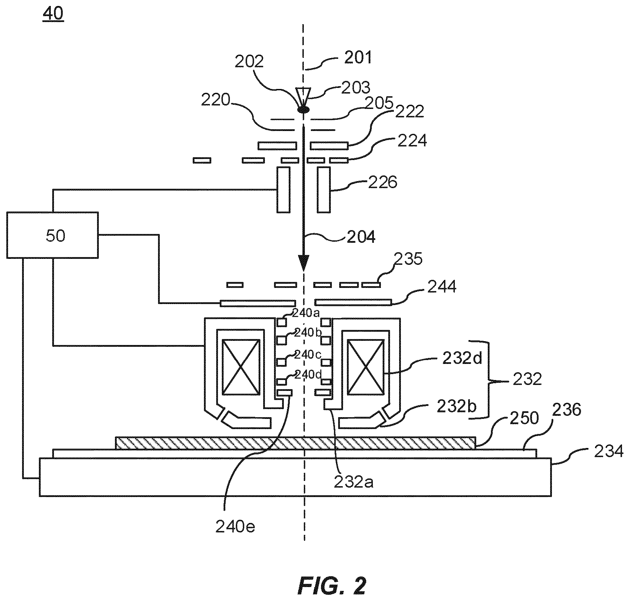

Reference is now made to Fig. 2, which illustrates a schematic diagram illustrating an exemplary configuration of electron beam tool 40 that can be a part of the exemplary charged particle beam inspection system 100 of Fig. 1, consistent with embodiments of the present disclosure. Electron beam tool 40 (also referred to herein as apparatus 40) may comprise an electron emitter, which may comprise a cathode 203, an extractor electrode 205, a gun aperture 220, and an anode 222. Electron beam tool 40 may further include a Coulomb aperture array 224, a condenser lens 226, a beam-limiting aperture array 235, an objective lens assembly 232, and an electron detector 244. Electron beam tool 40 may further include a sample holder 236 supported by motorized stage 234 to hold a sample 250 to be inspected. It is to be appreciated that other relevant components may be added or omitted, as needed.

In some embodiments, electron emitter may include cathode 203, an anode 222, wherein primary electrons can be emitted from the cathode and extracted or accelerated to form a primary electron beam 204 that forms a primary beam crossover 202. Primary electron beam 204 can be visualized as being emitted from primary beam crossover 202.

In some embodiments, the electron emitter, condenser lens 226, objective lens assembly 232, beam-limiting aperture array 235, and electron detector 244 may be aligned with a primary optical axis 201 of apparatus 40. In some embodiments, electron detector 244 may be placed off primary optical axis 201, along a secondary optical axis (not shown).

Objective lens assembly 232, in some embodiments, may comprise a modified swing objective retarding immersion lens (SORIL), which includes a pole piece 232a, a control electrode 232b, a beam manipulator assembly comprising deflectors 240a, 240b, 240d, and 240e, and an exciting coil 232d. In a general imaging process, primary electron beam 204 emanating from the tip of cathode 203 is accelerated by an accelerating voltage applied to anode 222. A portion of primary electron beam 204 passes through gun aperture 220, and an aperture of Coulomb aperture array 224, and is focused by condenser lens 226 so as to fully or partially pass through an aperture of beam-limiting aperture array 235. The electrons passing through the aperture of beam-limiting aperture array 235 may be focused to form a probe spot on the surface of sample 250 by the modified SORIL lens and deflected to scan the surface of sample 250 by one or more deflectors of the beam manipulator assembly. Secondary electrons emanated from the sample surface may be collected by electron detector 244 to form an image of the scanned area of interest.

In objective lens assembly 232, exciting coil 232d and pole piece 232a may generate a magnetic field. A part of sample 250 being scanned by primary electron beam 204 can be immersed in the magnetic field and can be electrically charged, which, in turn, creates an electric field. The electric field may reduce the energy of impinging primary electron beam 204 near and on the surface of sample 250. Control electrode 232b, being electrically isolated from pole piece 232a, may control, for example, an electric field above and on sample 250 to reduce aberrations of objective lens assembly 232 and control focusing situation of signal electron beams for high detection efficiency, or avoid arcing to protect sample. One or more deflectors of beam manipulator assembly may deflect primary electron beam 204 to facilitate beam scanning on sample 250. For example, in a scanning process, deflectors 240a, 240b, 240d, and 240e can be controlled to deflect primary electron beam 204, onto different locations of top surface of sample 250 at different time points, to provide data for image reconstruction for different parts of sample 250. It is noted that the order of 240a-e may be different in different embodiments.

Backscattered electrons (BSEs) and secondary electrons (SEs) can be emitted from the part of sample 250 upon receiving primary electron beam 204. A beam separator 240c can direct the secondary or scattered electron beam(s), comprising backscattered and secondary electrons, to a sensor surface of electron detector 244. The detected secondary electron beams can form corresponding beam spots on the sensor surface of electron detector 244. Electron detector 244 can generate signals (e.g., voltages, currents) that represent the intensities of the received secondary electron beam spots, and provide the signals to a processing system, such as controller 50. The intensity of secondary or backscattered electron beams, and the resultant secondary electron beam spots, can vary according to the external or internal structure of sample 250. Moreover, as discussed above, primary electron beam 204 can be deflected onto different locations of the top surface of sample 250 to generate secondary or scattered electron beams (and the resultant beam spots) of different intensities. Therefore, by mapping the intensities of the secondary electron beam spots with the locations of sample 250, the processing system can reconstruct an image that reflects the internal or external structures of wafer sample 250.

In some embodiments, controller 50 may comprise an image processing system that includes an image acquirer (not shown) and a storage (not shown). The image acquirer may comprise one or more processors. For example, the image acquirer may comprise a computer, server, mainframe host, terminals, personal computer, any kind of mobile computing devices, and the like, or a combination thereof. The image acquirer may be communicatively coupled to electron detector 244 of apparatus 40 through a medium such as an electrical conductor, optical fiber cable, portable storage media, IR, Bluetooth, internet, wireless network, wireless radio, among others, or a combination thereof. In some embodiments, the image acquirer may receive a signal from electron detector 244 and may construct an image. The image acquirer may thus acquire images of regions of sample 250. The image acquirer may also perform various post-processing functions, such as generating contours, superimposing indicators on an acquired image, and the like. The image acquirer may be configured to perform adjustments of brightness and contrast, etc. of acquired images. In some embodiments, the storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

In some embodiments, controller 50 may include measurement circuitries (e.g., analog-to-digital converters) to obtain a distribution of the detected secondary electrons and backscattered electrons. The electron distribution data collected during a detection time window, in combination with corresponding scan path data of a primary beam 204 incident on the sample (e.g., a wafer) surface, can be used to reconstruct images of the wafer structures under inspection. The reconstructed images can be used to reveal various features of the internal or external structures of sample 250, and thereby can be used to reveal any defects that may exist in the wafer.

In some embodiments, controller 50 may control motorized stage 234 to move sample 250 during inspection. In some embodiments, controller 50 may enable motorized stage 234 to move sample 250 in a direction continuously at a constant speed. In other embodiments, controller 50 may enable motorized stage 234 to change the speed of the movement of sample 250 over time depending on the steps of scanning process.

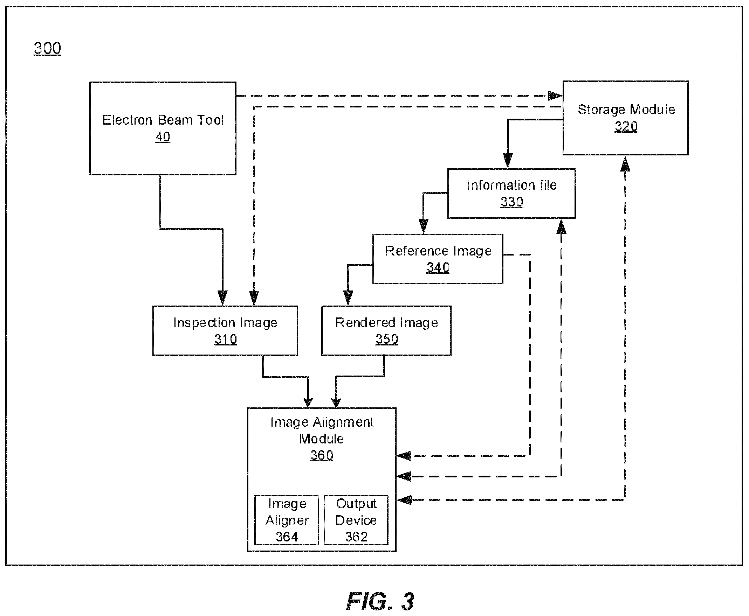

Reference is now made to Fig. 3, which illustrates a schematic diagram of an exemplary metrology system 300, consistent with embodiments of the present disclosure. In some embodiments, metrology system 300 may comprise electron beam tool 40 comprising an image processing system (not shown) configured to acquire and generate an inspection image 310, a storage module 320 configured to store data associated with apparatus 400, for example, and an image alignment module 360. Alternatively, metrology system 300 may be a part of apparatus 40 of Fig. 2 or EBI system 100 of Fig. 1.

Although not illustrated, image acquirer (discussed in reference to Fig. 2) of image processing system may be configured to capture inspection image 310. In some embodiments, inspection image 310 may include a high-resolution charged-particle beam image of a pattern on a sample. As used herein, high-resolution charged-particle beam image refers to an image having a resolution high enough to resolve two distinct features in the image having a spacing less than 20 nm and captured using a charged-particle beam apparatus such as, but not limited to, electron beam tool 40. Inspection image 310 may be acquired using an image acquirer of image processing system or any such system capable of acquiring high-resolution images. Inspection image 310 may be acquired by any charged-particle beam system that may generate an inspection image of a sample. The sample may be a semiconductor wafer substrate, or a semiconductor wafer substrate having one or more epi-layers or process films, for example. The embodiments of the present disclosure do not limit the specific type of an inspection system as long as the system may generate a wafer image having an adequate resolution.

In some embodiments, inspection image 310 may be a review-mode image, which is an image acquired under acquisition conditions intended to be optimal. The review-mode image may have a higher resolution, for example, optimized magnification, optimized contrast and brightness, optimized charged-particle beam intensity, etc., obtained, at least using optimized detector settings to acquire high-resolution images. In some embodiments, inspection image 310 may be a low-resolution image of a sample, or a feature on a wafer (e.g., wafer 250 of Fig. 2), or a region of interest on a substrate, for example. Inspection image 310 may be acquired using an image acquirer of image processing system or any such system capable of acquiring low-resolution images. Inspection image 310 may be acquired by any charged-particle beam inspection system, such as a SEM, that may generate an inspection image of a wafer or a region of interest on the wafer.

In some embodiments, inspection image 310 may be acquired in an offline mode. As used herein, "offline" mode refers to an operation mode of image acquirer or EBI system 100 when the system is not being utilized for wafer processing in a production run. For example, offline mode may comprise operation of image acquirer or EBI system 100 before the actual inspection begins or before an actual processing run. In some embodiments, inspection image 310 may be acquired by an image acquirer located apart from the process equipment, for example, including a stand-alone EBI system or an image acquirer. Acquiring inspection image 310 in offline mode may help significantly increase throughput of SEM inspection tools since image alignment may be performed by comparing an already existing reference image to an already existing inspection image 310.

Inspection image 310 may be stored in a local storage unit of image processing system, in a storage module 320 of metrology system 300, or in a remote storage location (not illustrated), for example, a remote database, a network, a server, a cloud platform, or the like, accessible by components of metrology system 300, including image alignment module 360. Storage module 320 may be further configured to share stored information with the components of metrology system 300, including image alignment module 360, electron beam tool 40, for example. In some embodiments, storage module 320 may be an integrated storage medium of image alignment module 360, configured to connect with each of the components thereof. Storage module 320 may be a remote storage module accessible through wireless communications over the Internet, a cloud platform, or suitable Wi-fi communication pathways, for example. In some embodiments, storage module 320 may comprise a database configured to store information. The database may also be configured to store images or other related information, for example, guidance parameters, quality metrics, etc. In some embodiments, a database may be directly coupled with image alignment module 360, for example. A database may include, for example, Oracle™ databases, Sybase™ databases, relational databases, or non-relational databases, such as Hadoop™ sequence files, HBase™, or Cassandra™. A database may include computing components (e.g., database management system, database server, etc.) configured to receive and process requests for data stored in memory devices of database and to provide data from database. In some embodiments, a database may take the form of a server, a computer, a mainframe computer, or any combination of these components. Other implementations consistent with disclosed embodiments are possible as well.

In some embodiments, storage module 320 may comprise information file 330 configured to store information including, but not limited to, associated with a wafer design, tool condition, tool parameters, product design, process design, defect analysis, among other things. For example, information file 330 may comprise a wafer design layout in Graphic Database System (GDS) format, Graphic Database System II (GDS II) format including a graphical representation of the features on the wafer surface, or an Open Artwork System Interchange Standard (OASIS) format. The wafer design layout may be based on a pattern layout for constructing the wafer. The wafer design layout may correspond to one or more photolithography masks or reticles used to transfer features from the photolithography masks or reticles to the wafer, for example. GDS information file or OASIS information file may comprise feature information stored in a binary file format representing planar geometric shapes, text, and other information related to wafer design layout. OASIS format may help significantly reduce data volume, resulting in a more efficient data transfer process. A large amount of GDS or OASIS format images may have been collected and may make up a large dataset of comparison features.

Information file 330 may further comprise knowledges or feature library, which may include information associated features or patterns on a wafer, for example, relative orientation of structures, physical location information of features on the wafer, x-y location coordinates of features on a wafer, spacing between the features, or the like. In some embodiments, information file 330 may contain information associated with critical dimensions and critical dimension tolerances for optical photolithography. In some embodiments, information file 330 may include target GDS information, target GDSII information, target OASIS information, among other things.

In some embodiments, information file 330 may comprise reference image 340, also referred to herein as a "training" image. Reference image may be formed based on the stored information associated with one or more reference features. As an example, a reference image comprising a two-dimensional image of a feature such as a contact pad, having reference location coordinates, reference dimensions, reference orientation, or the like, may be formed based on data stored. Reference image 340 may comprise a binary image, a gray-scale image, or an optical image.

Rendered image 350 may comprise two-dimensional or three-dimensional rendering of a corresponding reference image (e.g., reference image 340), or a modification of an existing image. In some embodiments, rendered image 350 may comprise including, but not limited to, a GDS rendered image, an OASIS rendered image, or a GDSII rendered image. Rendered image 350 may be formed by convoluting a reference image represented by a matrix of pixels, with a "kernel" represented by a two-dimensional matrix of numbers. Image processing techniques including blurring, sharpening, smoothing, edge detection, etc. may be performed by applying kernels across an image. The size of a kernel may range in dimensions, for example, a 3x3, or a 5x5, or a m x n matrix, where m and n are integers. A rendered image may be created by, for example, a mathematical operation, also known as convolution, between a matrix of a reference image and a filter kernel, and a characteristic of the resultant rendered image may be based on a characteristic of the filter kernel such as, a size, of a blurring kernel, or a sharpening kernel, etc.

Metrology system 300 may further include image alignment module 360 configured to receive at least inspection image 310 and rendered image 340, and align inspection image 310 with the rendered image 340. Image alignment module 360 may comprise an image aligner 364 and an output device 362. In some embodiments, although not illustrated, image alignment module 360 may further comprise one or more processors, or a data storage module.

Image alignment module 360 may be configured to receive one or more inspection images, reference images, or rendered images in a suitable format, for example, a Joint Photographic Experts Group (JPEG) file, a Portable Network Graphic (PNG) file, a Portable Document Format (PDF) file, a Tagged Image File Format (TIFF) file, etc. Other suitable formats of images may also be used. Image alignment module 360 may be configured to receive images from one or more sources, including, but not limited to, storage module 320, a remote database, electron beam tool 40, EBI system 100, or the like.

In some embodiments, image aligner 364 of image alignment module 360 may include a processor configured to execute a set of instructions to cause image alignment module 360 to perform associated functions. Image aligner 364 may comprise a computing unit, a computer, a programmable IC circuit, a mainframe computer, a server, etc. and may be coupled with output device 362, either through a wired connection or wirelessly. In some embodiments, output device 362 may be integrated within image aligner 364. Alternatively or additionally, output device 362 may not be part of image aligner 364 or image alignment module 360. Image aligner 364 may be configured to execute one or more of a software-implemented algorithm, image-processing algorithm, feature-identification or feature-extraction algorithm, edge-detection algorithm, or the like.

In some embodiments, image aligner 364 or image alignment module 360 may include memory (not shown) configured to store instructions for a processor. The memory may comprise a non-volatile memory, random access memory (RAM), dynamic random access memory (DRAM), static random access memory (SRAM), read-only memory (ROM), flash memory, or the like. In some embodiments, image alignment module 360 may comprise one or more memories based on, for example, the volume of data and information that needs to be processed, or as desired.

Image alignment module 360 may further comprise output device 362 configured to display information associated with alignment of inspection image 310 with rendered image 350 or reference image 340, or both. In some embodiments, output device 362 may comprise a handheld display device, a TV screen, a computer screen, a multi-screen display, an interactive display device, or the like. Other suitable display devices may be used as well. Output device 362 may be integrated within image aligner 364, or within image alignment module 360, or within metrology system 300. In some embodiments, output device 362 may be a stand-alone, separate display device located in a remote location and operated independently of image alignment module 360.

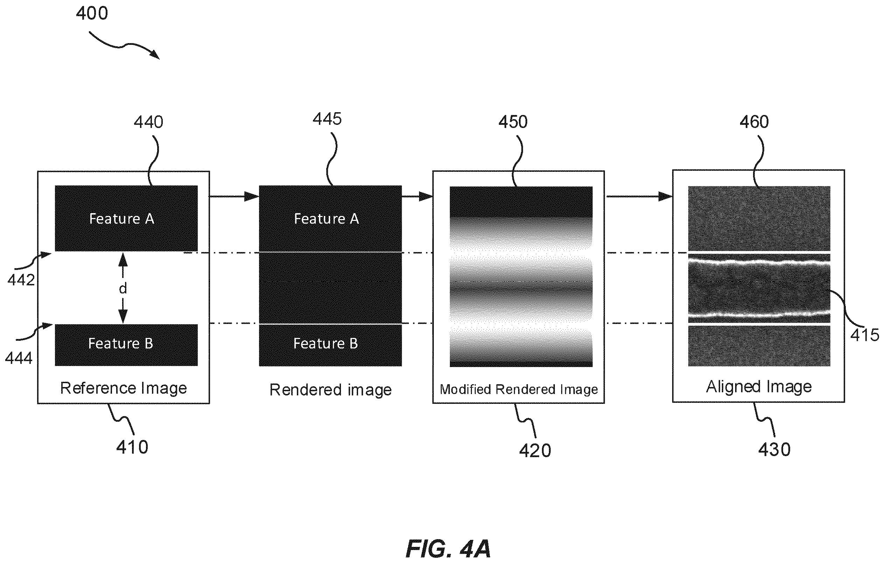

Reference is now made to Fig. 4A, which is an exemplary flowchart illustrating an image alignment method 400, consistent with embodiments of the present disclosure. The image alignment method may be performed by image alignment module 360 that may be coupled with a charged particle beam apparatus, including EBI system 100. It is appreciated that the charged particle beam apparatus may be controlled to image a wafer or a region of interest on the wafer. Imaging may comprise scanning a wafer to image at least a portion of the wafer, a pattern on the wafer, or the wafer itself. Aligning may comprise aligning the acquired inspection image with a rendered image such as a GDS rendered image of a reference image corresponding to the inspection image, such that a topology of the reference image is substantially preserved in the rendered image. The term "substantially preserved," as used herein, refers to the topology characteristics of a modified image that are unchanged or similar in comparison to the original topology characteristics before modification of the image. For example, if two features represented by parallel lines in a reference (original) image remain parallel in the modified image, such as a downsampled or an upsampled image, the topology is considered to be "substantially preserved."

In step 410, image alignment module 360 may obtain information associated with a reference image 440 corresponding to an inspection image 415, or may obtain reference image 440 itself. Reference image 440 may comprise an original GDS image of a pattern, or of a region of a wafer corresponding to the pattern or the region of the inspection image. Image alignment module 360 may obtain inspection image 415, either from a storage module (e.g., storage module 320 of Fig. 3) or from an output file of an electron beam tool (e.g., electron beam tool 40 of Fig. 2) configured to generate a high-resolution charged-particle beam image, for example. Reference image 440 may be, for example, a binary scale image, a grayscale image, an optical image, or a digital image, corresponding to the inspection image to be aligned. In some embodiments, image alignment module 360 may obtain the information associated with a reference image corresponding to inspection image 415 and generate reference image 440, or may obtain an already existing reference image 440 from an information file (e.g., information file 330 of Fig. 3) of the storage module.

Image alignment module 360 may further determine a topology or a characteristic of the topology of reference image 440. As an example, image alignment module 360 may determine that reference image 440, shown in Fig. 4A is an image of a region comprising two features, Feature A and Feature B, having parallel boundaries 442 and 444, respectively, spaced by a distance d. In this scenario, the topology of original GDS image or reference image 440 may comprise, at least two features having parallel boundaries, and a finite spacing d between the two features.

Image-alignment module 360 may comprise a processor configured to execute a set of instructions such as a software-implemented algorithm, for example, to form a rendered image 445 and determine a topology or a characteristic of the topology therefrom. Rendered image 445 may comprise a GDS rendered image, for example. Rendering an image may include selection of parameters, among other things, to identify a feature based on either an interior (e.g., FILL parameter), or a boundary (e.g., EDGE parameter) of the feature within the image. As an example, rendered image 445 may comprise an edge-rendered GDS image of reference image 440, where boundaries 442 and 444 of the space between Feature A and Feature B are identified. Rendered image 445 may be a binary image where the identified patterns of interest (e.g., boundaries 442 and 444) are represented by pixel intensity "1" and the remaining regions are represented by pixel intensity "0."

In step 420, image alignment module 360 may modify rendered image 445 to form a modified rendered image 450 such that the modification substantially preserves the topology of rendered image 445. A modified rendered image may comprise a blurred-edge rendered image (e.g., modified rendered image 450 of Fig. 4A), or a blurred-fill rendered image, or the like. By way of example, modified rendered image 450, formed by modifying rendered image 445, illustrates two substantially parallel and physically resolvable lines separated by a distance therebetween. The topology of rendered image 445 is substantially preserved in modified rendered image 450..

In some embodiments, modification of rendered image 445 may comprise formation of a grayscale image from a binary scale image by way of downsampling rendered image 445. In the context of this disclosure, and in the context of image processing, downsampling refers to downscaling an image such that the spatial resolution is reduced while maintaining the two-dimensional representation of the image. Downsampling an image may cause blurring of an image, or one or more features of an image. Some of the advantages of downsampling may include, but are not limited to, manageability of data, reduction in dimensionality of data thus enabling faster processibility of the data, and reducing the data storage size, among other benefits. In some embodiments, modification of rendered image 445 may comprise upsampling of rendered image 445. Upsampling refers to improving the spatial resolution while maintaining the two-dimensional representation of an image. Upsampling may cause smoothing or sharpening of an image, or one or more features of an image.

In some embodiments, modification of rendered image 445 may be based on the topology of rendered image 445. Rendered image 445 may be blurred, for example, by downsampling, based on the topology such that the blurring may substantially preserve the topology or a characteristic of the topology. For example, downsampling of rendered image 445 may cause blurring of boundaries 442 and 444 such that modified rendered image 450 still comprises two features having parallel boundaries, and a finite spacing between the boundaries. In some embodiments, the degree or extent of modification of rendered image 445, referred to herein as a downsampling scale or a downsampling ratio, may be based on the topology or a characteristic of the topology comprising a size, a shape, an orientation, or a boundary of a feature, or a spacing between adjacent features of the reference image.

Downsampling an image generally results in blurring of features of the image. The downsampling scale, in some embodiments, may be limited to a maximum value such that a characteristic of the topology is substantially preserved, as illustrated in modified rendered image 450. The maximum value of downsampling scale may be defined as the value of downsampling scale until a number of connected features in the rendered image remain unchanged. The maximum value of downsampling ratio may be based on a characteristic of the topology of rendered image 445. As an example, if Feature A and Feature B of reference image 440 are physically separated by a distance d, the maximum downsampling scale may be less than x. If rendered image 445 is downsampled beyond the maximum downsampling ratio, boundary lines 442 and 444 may merge to form a single physically unresolvable feature, causing the image alignment mechanism to fail. In some embodiments, image aligner 364 of image alignment module 360 may perform downsampling of rendered image 445 to form modified rendered image 450 prior to aligning reference image with inspection image 310.

In some embodiments, rendered image 445 may be modified to form modified rendered image 450 by, for example, convoluting rendered image 445 with a filter kernel. Therefore, it may be beneficial to optimize one or more characteristics of the filter kernel applied to rendered image 445 to form modified rendered image 450. Optimizing the characteristic of filter kernel may include, but is not limited to, adjusting a size, adjusting a convolution (mathematical operation), adjusting one or more elements of filter kernel, adjusting an offset, adjusting a blurring function including Gaussian blur or convex blur, among other things. For example, a combination of a blurring function and a kernel size may be used to modify rendered image 445 to form a modified rendered image 450. Other combinations may be used as well, as appropriately desired.

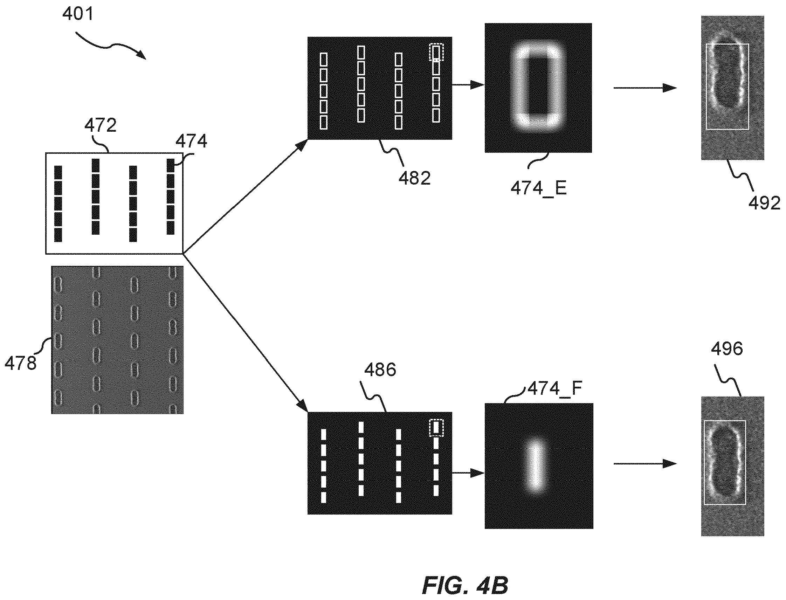

Reference is now made to Fig. 4B, which illustrates an exemplary method 401 of image alignment based on parameter selection for image rendering, consistent with embodiments of the present disclosure. An image aligner (e.g., image aligner 364 of Fig. 3) or image alignment module 360 of Fig. 3, may be configured to perform one or more steps of method 401. It is appreciated that other components of metrology system 300 or the metrology system 300 itself may perform one or more steps of method 401.

Image alignment method 401 may comprise obtaining a reference image 472 and a corresponding inspection image 478. Reference image 472 and inspection image 478 may comprise input images, also referred to herein as original images. Reference image may comprise a GDS image, for example, of features 474 arranged in an array. Inspection image 478 may comprise a SEM image, for example, of corresponding features 474, as fabricated on a wafer or a substrate.

In some embodiments, image alignment method 401 may further comprise rendering reference image 472 to form a rendered image 482. Rendering reference image 472 may include rendering based on a selection of one or more parameters including, but not limited to, feature type, feature intensity, minimum and maximum scales for sampling, among other things. As seen in Fig. 4B, rendered image 482 may comprise a rendered GDS image based on "EDGE" selection for rendering feature 474. In some embodiments, the image alignment method may further comprise rendering reference image 472 to form a rendered image 486 comprising a rendered GDS image based on "FILL" selection for rendering feature 474.

Image alignment method 401 may further comprise modifying rendered image 482 to form a modified rendered image (not shown) comprising edge-modified feature 474_E, or modifying rendered image 486 to form a modified rendered image (not shown) comprising fill-modified feature 474_F. Modification of a feature to produce modified rendered images from rendered images 482 and 486 may comprise downsampling rendered image based on the topology or a characteristic of the topology of rendered image. As seen in Fig. 4B, downsampling rendered image 482 may cause edges of feature 474 to blur, producing modified feature 474_E; and downsampling rendered image 486 may cause the interior of feature 474 to blur, producing modified feature 474_F. The downsampling ratio or downsampling scale may be determined based on the topology of the rendered image being downsampled, as discussed in reference to Fig. 4A.

Image alignment method 401 may further comprise aligning inspection image 478 with reference image 472 based on an alignment between inspection image 478 and modified rendered image comprising modified features (e.g., modified feature 474_E or 474_F). Aligned image 492 represents an exemplary alignment between inspection image 478 and reference image 472 based on an alignment between a feature of inspection image 478 corresponding to feature 474 and edge-modified feature 474_E. In some embodiments, aligned image 496 represents an exemplary alignment between inspection image 478 and reference image 472 based on an alignment between a feature of inspection image 478 corresponding to feature 474 and fill-modified feature 474_F.

In the semiconductor industry, edge placement error (EPE) refers to the difference between the intended and the printed features of an IC layout. One of several sources of EPE may be the requirement of precise patterning of nanometer-sized features in precise locations. For example, a feature could be a metal line or an interconnect, and that line has right and left edges. In a device configuration, the line and its edges must be precise and placed in exact locations. Failure to fabricate and position the line at precise location may result in misalignment or an EPE, subjecting the device to electrical shorts or poor yields, which could cause the entire chip to fail. For some applications, as the acceptable edge placement error (EPE) reduces to 0.5 nm and below, it may be beneficial to reliably and repeatably measure EPE. However, a highly repeatable alignment may be challenging, partly because inspection images may differ from the reference images in intensity, brightness, noise levels, sharpness, dimensions, image acquisition tool conditions, among other things.

Although currently existing die-to-database (D2DB) alignment techniques for aligning inspection images with reference images such as edge-based alignment and plain-correlation alignment offer some advantages, the achievable repeatability and precision of alignment may be inadequate for shrinking device geometries, particularly in DRAM devices. One of several issues limiting the alignment precision includes edge-toward drift. To mitigate the effect of edge-toward drift on EPE, it may be beneficial to provide a method for repeatably and precisely aligning inspection images to the center of reference GDS patterns, for example.

In some disclosed embodiments, the method for aligning inspection image with a reference GDS image may include an adaptive filter mechanism for the plain-correlation technique. The adaptive filter mechanism may include modifying a reference GDS image using a convolutional matrix, based on the topology or a characteristic of the topology of reference GDS image. If the width of an inspection feature in an inspection image is ws, and the width of a corresponding reference GDS feature is wG, then the optimal distance x' from the edge of inspection feature to the edge of reference GDS feature may be represented by equation 1.

$$x' = \frac{w_G - w_s}{2} \qquad \text{(Eq. 1)}$$

To ensure that the correlation index maximizes at $x'$, the filter kernel $f$ must satisfy:

$$f(x') \geq \frac{f(x) + f(w_G - w_s - x)}{2}, \forall x \in [0, w_G] \qquad \text{(Eq. 2)}$$

If filter kernel f is implemented as an impulse function, as shown in reference image 440, the correlation index may be maximized when

$$x = 0 \text{ or } w_G - w_s \qquad \text{(Eq. 3)}$$

Referring again to Fig. 4A, in some embodiments, a convex blurring kernel comprising an ellipse or a ball function may securely locate an inspection feature to the center of a reference GDS feature. In some embodiments, modifying rendered image 445 to form modified rendered image 450 may further comprise selecting a kernel size, s. Further, it may be desirable to identify a kernel having a kernel size $s'$, which when convoluted with rendered image 445, results in maximum downsampling while substantially preserving the topology of rendered image 445. A maximum kernel size $s'$ may be determined based on a characteristic of the topology. For example, maximum kernel size s' may be determined based on a spacing between feature A and feature B in rendered image 445. If $s < s'$, a centered alignment between rendered image 445 and inspection image may be obtained, however, if s > s', a centered alignment may fail because the topology of the rendered GDS image may have changed. Additionally, if s << s', it may be challenging to centrally align inspection image with rendered image 445, and therefore resulting in misaligned inspection image with reference image 440.

As an example, if the spacing between boundaries 442 and 444 of features A and B, respectively, is 80 nm, a GDS rendered image with a filter kernel of size 40-79 nm may result in centered alignment between inspection image 415 and reference image 440. In a case where reference image 440 is rendered with a kernel size 80 nm and above, the centered alignment will fail because the topology, such as, for example, spacing between boundaries 442 and 444, may change.

In step 430, image aligner 364 of image alignment module 360 may align inspection image 415, analogous to inspection image 310 of Fig. 3, with modified rendered image 450. Image aligner 364 may further align inspection image 415 (e.g., a SEM image) with reference image 440 based on an alignment between inspection image 415 and modified rendered image 450 to form aligned image 460.

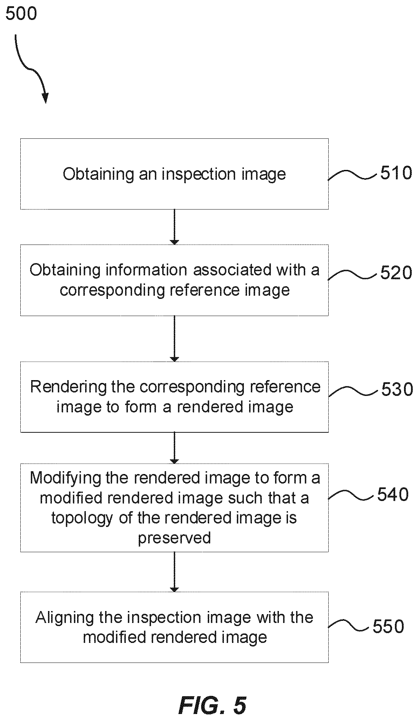

Reference is now made to Fig. 5, which illustrates an exemplary process flowchart representing a method 500 of image alignment using metrology system 300 of Fig. 3, consistent with embodiments of the present disclosure. The steps of method 500 may be performed by image alignment module 360 of Fig. 3 executing on or otherwise using the features of a computing device, e.g., controller 50 of Fig. 1 for purposes of illustration. It is appreciated that illustrated method 500 can be altered to modify the order of steps and to include additional steps or omit steps.

In step 510, image alignment module 360 may obtain an inspection image (e.g., inspection image 310 of Fig. 3). Inspection image may be a charged-particle beam image such as an electron-beam image of a pattern, or a region, or a feature on a wafer. Inspection image may be a high-resolution electron beam image, a high-resolution optical image, a high-resolution digital image, or other image of an appropriate resolution usable for image alignment. Inspection image may be captured using an image acquirer of electron beam inspection system or electron beam tool (e.g., electron beam tool 40 of Fig. 2). In some embodiments, inspection image may be acquired and stored temporarily in a storage module (e.g., storage module 320 of Fig. 3). The image alignment module may access or obtain the inspection image, as needed.

In step 520, the image alignment module may obtain information associated with a reference image (e.g., reference image 340 of Fig. 3 or reference image 440 of Fig. 4A) corresponding to the inspection image. The information associated with the reference image may be stored in an information file (e.g., information file 330 of Fig. 3) in the storage module. The information may be stored as a wafer design layout information in Graphic Database System (GDS) format, Graphic Database System II (GDS II) format including a graphical representation of the features on the wafer surface, or an Open Artwork System Interchange Standard (OASIS) format. GDS information file or OASIS information file may comprise feature information stored in a binary file format representing planar geometric shapes, text, and other information related to wafer design layout. A processor of image alignment module may determine the information associated with the pattern or feature corresponding to the inspection image, and import the determined information in GDS format or a reference GDS image into a storage unit of the image alignment module.

In step 530, the image alignment module may form a rendered image (e.g., rendered image 445) based on the information associated with the corresponding reference image, and determine a topology or a characteristic of the topology therefrom. The rendered image may comprise a GDS rendered image, for example. Rendering an image may include selection of parameters, among other things, to identify a feature based on either an interior (e.g., FILL parameter), or a boundary (e.g., EDGE parameter) of the feature within the image. As an example, the rendered image may comprise an edge-rendered GDS image of the reference image, or a fill-rendered GDS image of the reference image. Rendered image 445 may be a binary image.

In step 540, the image alignment module may modify the rendered image based on a topology of the rendered image to form a modified rendered image (e.g., modified rendered image 450 of Fig. 4A), such that the topology of the rendered image is substantially preserved. Modification of the rendered image may comprise formation of a grayscale image from a binary scale image by way of downsampling the rendered image. In some embodiments, modification of the rendered image may be based on the topology of the rendered image. Rendered image may be blurred, for example, by downsampling, based on the topology such that the amount of blurring may substantially preserve the topology or a characteristic of the topology. In some embodiments, the degree or extent of modification of the rendered image, referred to herein as a downsampling scale or a downsampling ratio, may be based on the topology or a characteristic of the topology comprising a size, a shape, an orientation, or a boundary of a feature, or a spacing between adjacent features of the rendered image. The rendered image may be modified to form a modified rendered image by, for example, convoluting the rendered image with a filter kernel of a maximum size without changing the topology of the rendered image.

**In** step 550, the image alignment module may align the inspection image with the modified rendered image in step 540. The image alignment module may further align the inspection image with the corresponding reference image (e.g., a reference GDS image) based on the alignment between the inspection image and the rendered image to form an aligned image (e.g., aligned image 460 of Fig. 4A). The alignment may be based on the kernel size of the convolutional filter applied. For example, if the size of the filter kernel is less than the maximum kernel size that can substantially preserve the topology while downsampling, the inspection image may be aligned with the center of the corresponding GDS feature. If, however, the size of the kernel filter is greater than the maximum kernel size, the alignment may fail because the topology will have changed.

A non-transitory computer readable medium may be provided that stores instructions for a processor of a controller (e.g., controller 50 of Fig. 1) to carry out image inspection, image acquisition, activating charged-particle source, adjusting electrical excitation of stigmators, adjusting landing energy of electrons, adjusting objective lens excitation, , stage motion control, activating a beam deflector to deflect primary electron beam, applying electrical excitation signals including AC voltage, etc. Common forms of non-transitory media include, for example, a floppy disk, a flexible disk, hard disk, solid state drive, magnetic tape, or any other magnetic data storage medium, a Compact Disc Read Only Memory (CD-ROM), any other optical data storage medium, any physical medium with patterns of holes, a Random Access Memory (RAM), a Programmable Read Only Memory (PROM), and Erasable Programmable Read Only Memory (EPROM), a FLASH-EPROM or any other flash memory, Non-Volatile Random Access Memory (NVRAM), a cache, a register, any other memory chip or cartridge, and networked versions of the same.

The block diagrams in the figures illustrate the architecture, functionality, and operation of possible implementations of systems, methods, and computer hardware/software products according to various exemplary embodiments of the present disclosure. In this regard, each block in a schematic diagram may represent certain arithmetical or logical operation processing that may be implemented using hardware such as an electronic circuit. Blocks may also represent a module, a segment, or a portion of code that comprises one or more executable instructions for implementing the specified logical functions. It should be understood that in some alternative implementations, functions indicated in a block may occur out of the order noted in the figures. For example, two blocks shown in succession may be executed or implemented substantially concurrently, or two blocks may sometimes be executed in reverse order, depending upon the functionality involved. Some blocks may also be omitted.

It will be appreciated that the embodiments of the present disclosure are not limited to the exact construction that has been described above and illustrated in the accompanying drawings, and that various modifications and changes may be made without departing from the scope thereof. The present disclosure has been described in connection with various embodiments, other embodiments of the invention will be apparent to those skilled in the art from consideration of the specification and practice of the invention disclosed herein.

The descriptions above are intended to be illustrative, not limiting. Thus, it will be apparent to one skilled in the art that modifications may be made as described without departing from the scope of the claims set out below.

## Claims

1. An image alignment method comprising:

   obtaining an image (310) of a sample (250);
   obtaining information (330) associated with a corresponding reference image (440);
   generating a modified rendered image (450) by modifying a rendered image of the corresponding reference image such that a topology of the rendered image is substantially preserved; and
   aligning the image of the sample with the modified rendered image.

2. The image alignment method of claim 1, further comprising aligning the image of the sample with the corresponding reference image based on an alignment between the image of the sample and the modified rendered image.

3. The image alignment method of any one of claims 1 and 2, further comprising modifying the rendered image based on a characteristic of the topology of the rendered image.

4. The image alignment method of claim 3, wherein the characteristic of the topology comprises a size, a shape, an orientation, or a boundary of a feature, or a spacing between adjacent features of the rendered image.

5. The image alignment method of any one of claims 1-4, wherein modifying the rendered image comprises downsampling the rendered image based on a downsampling scale, the downsampling scale based on the characteristic of the topology.

6.  The image alignment method of claim 5, wherein downsampling the rendered image is based on a maximum value of the downsampling scale that substantially preserves the topology of the rendered image.

7.  The image alignment method of any one of claims 5 and 6, wherein downsampling the rendered image is performed using a convex blurring function.

8.  The image alignment method of claim 7, wherein the convex blurring function comprises an ellipse function.

9.  The image alignment method of any one of claims 5-8, wherein downsampling the corresponding reference image causes blurring of the rendered image.

10. The image alignment method of any one of claims 1-9, wherein the image of the sample comprises a charged-particle beam image, an optical image, or a digital image.

11. The image alignment method of any one of claims 1-10, wherein the information associated with the corresponding reference image comprises information in Graphic Database System, GDS, format, Graphic Database System II, GDS II, format, or an Open Artwork System Interchange Standard, OASIS, format.

12. An image alignment system comprising:

    a memory storing a set of instructions; and
    a processor configured to execute the set of instructions to cause the image alignment system to:

       obtain an image (310) of a sample (250);
       obtain information (330) associated with a corresponding reference image (440);
       generate a modified rendered image (450) by modifying a rendered image of the corresponding reference image such that a topology of the rendered image is substantially preserved; and

    align the image of the sample with the modified rendered image.

13. The image alignment system of claim 12, wherein the set of instructions further causes the image alignment system to align the image of the sample with the corresponding reference image based on an alignment between the image of the sample and the modified rendered image.

14. The image alignment system of any one of claims 12 and 13, wherein the set of instructions further causes the image alignment system to modify the rendered image based on a characteristic of the topology of the rendered image, and wherein the characteristic of the topology comprises a size, a shape, an orientation, or a boundary of a feature, or a spacing between adjacent features of the rendered image.

15. The image alignment system of claim 14, wherein the set of instructions further cause the image alignment system to downsample the rendered image based on a downsampling scale, the downsampling scale based on the characteristic of the topology, and wherein downsampling is based on a maximum value of the downsampling scale that substantially preserves the topology of the rendered image.


**Patentansprüche**

1.  Ein Bildausrichtungsverfahren, das Folgendes beinhaltet:

    Erhalten eines Bildes (310) eines Probestücks (250);
    Erhalten von Informationen (330), die mit einem entsprechenden Referenzbild (440) assoziiert sind;
    Erzeugen eines modifizierten gerenderten Bildes (450) durch Modifizieren eines gerenderten Bildes des entsprechenden Referenzbildes, sodass eine Topologie des gerenderten Bildes im Wesentlichen bewahrt wird; und
    Ausrichten des Bildes des Probestücks nach dem modifizierten gerenderten Bild.

2.  Bildausrichtungsverfahren gemäß Anspruch 1, das ferner das Ausrichten des Bildes des Probestücks nach dem entsprechenden Referenzbild auf der Basis einer Ausrichtung untereinander zwischen dem Bild des Probestücks und dem modifizierten gerenderten Bild beinhaltet.

3. Bildausrichtungsverfahren gemäß einem der Ansprüche 1 und 2, das ferner das Modifizieren des gerenderten Bildes auf der Basis eines Charakteristikums der Topologie des gerenderten Bildes beinhaltet.

4. Bildausrichtungsverfahren gemäß Anspruch 3, wobei das Charakteristikum der Topologie eine Größe, eine Form, eine Orientierung oder eine Grenze einer Struktur oder einen Abstand zwischen benachbarten Strukturen des gerenderten Bildes beinhaltet.

5. Bildausrichtungsverfahren gemäß einem der Ansprüche 1-4, wobei das Modifizieren des gerenderten Bildes das Downsampling des gerenderten Bildes auf der Basis eines Downsampling-Maßstabs beinhaltet, wobei der Downsampling-Maßstab auf dem Charakteristikum der Topologie basiert.

6. Bildausrichtungsverfahren gemäß Anspruch 5, wobei das Downsampling des gerenderten Bildes auf einem Maximalwert des Downsampling-Maßstabs, der die Topologie des gerenderten Bildes im Wesentlichen bewahrt, basiert.

7. Bildausrichtungsverfahren gemäß einem der Ansprüche 5 und 6, wobei das Downsampling des gerenderten Bildes unter Verwendung einer konvexen Unschärfefunktion durchgeführt wird.

8. Bildausrichtungsverfahren gemäß Anspruch 7, wobei die konvexe Unschärfefunktion eine Ellipsenfunktion beinhaltet.

9. Bildausrichtungsverfahren gemäß einem der Ansprüche 5-8, wobei das Downsampling des entsprechenden Referenzbildes eine Unschärfe des gerenderten Bildes bewirkt.

10. Bildausrichtungsverfahren gemäß einem der Ansprüche 1-9, wobei das Bild des Probestücks ein Ladungsträgerstrahlbild, ein optisches Bild oder ein digitales Bild beinhaltet.

11. Bildausrichtungsverfahren gemäß einem der Ansprüche 1-10, wobei die mit dem entsprechenden Referenzbild assoziierten Informationen Informationen im Format des Graphic Database System, GDS, im Format des Graphic Database System II, GDS II, oder in einem Format des Open Artwork System Interchange Standard, OASIS, beinhalten.

12. Ein Bildausrichtungssystem, das Folgendes beinhaltet:

einen Speicher, der einen Satz Anweisungen speichert; und
einen Prozessor, der konfiguriert ist, um den Satz Anweisungen auszuführen, um zu bewirken, dass das Bildausrichtungssystem:

ein Bild (310) eines Probestücks (250) erhält;
Informationen (330) erhält, die mit einem entsprechenden Referenzbild (440) assoziiert sind;
durch Modifizieren eines gerenderten Bildes des entsprechenden Referenzbildes, sodass eine Topologie des gerenderten Bildes im Wesentlichen bewahrt wird, ein modifiziertes gerendertes Bild (450) erzeugt; und
das Bild des Probestücks nach dem modifizierten gerenderten Bild ausrichtet.

13. Bildausrichtungssystem gemäß Anspruch 12, wobei der Satz Anweisungen ferner bewirkt, dass das Bildausrichtungssystem das Bild des Probestücks auf der Basis einer Ausrichtung untereinander zwischen dem Bild des Probestücks und dem modifizierten gerenderten Bild nach dem entsprechenden Referenzbild ausrichtet.

14. Bildausrichtungssystem gemäß einem der Ansprüche 12 und 13, wobei der Satz Anweisungen ferner bewirkt, dass das Bildausrichtungssystem das gerenderte Bild auf der Basis eines Charakteristikums der Topologie des gerenderten Bildes modifiziert, und wobei das Charakteristikum der Topologie eine Größe, eine Form, eine Orientierung oder eine Grenze einer Struktur oder einen Abstand zwischen benachbarten Strukturen des gerenderten Bildes beinhaltet.

15. Bildausrichtungssystem gemäß Anspruch 14, wobei der Satz Anweisungen ferner bewirkt, dass das Bildausrichtungssystem auf der Basis eines Downsampling-Maßstabs ein Downsampling des gerenderten Bildes durchführt, wobei der Downsampling-Maßstab auf dem Charakteristikum der Topologie basiert und wobei das Downsampling auf einem Maximalwert des Downsampling-Maßstabs, der die Topologie des gerenderten Bildes im Wesentlichen bewahrt, basiert.

**EP 4 264 373 B1**

**Revendications**

1.  Un procédé d'alignement d'images comprenant :

    l'obtention d'une image (310) d'un échantillon (250) ;
    l'obtention d'informations (330) associées à une image de référence correspondante (440) ;
    la génération d'une image de rendu modifiée (450) par modification d'une image de rendu de l'image de référence correspondante de telle sorte qu'une topologie de l'image de rendu est substantiellement préservée ; et
    l'alignement de l'image de l'échantillon avec l'image de rendu modifiée.

2.  Le procédé d'alignement d'images de la revendication 1, comprenant en sus l'alignement de l'image de l'échantillon avec l'image de référence correspondante sur la base d'un alignement entre l'image de l'échantillon et l'image de rendu modifiée.

3.  Le procédé d'alignement d'images de n'importe laquelle des revendications 1 et 2, comprenant en sus la modification de l'image de rendu sur la base d'une caractéristique de la topologie de l'image de rendu.

4.  Le procédé d'alignement d'images de la revendication 3, dans lequel la caractéristique de la topologie comprend une taille, une forme, une orientation, ou une délimitation d'un trait, ou un espacement entre des traits adjacents de l'image de rendu.

5.  Le procédé d'alignement d'images de n'importe laquelle des revendications 1 à 4, dans lequel la modification de l'image de rendu comprend le sous-échantillonnage de l'image de rendu sur la base d'une échelle de sous-échantillonnage, l'échelle de sous-échantillonnage étant basée sur la caractéristique de la topologie.

6.  Le procédé d'alignement d'images de la revendication 5, dans lequel le sous-échantillonnage de l'image de rendu est basé sur une valeur maximale de l'échelle de sous-échantillonnage qui préserve substantiellement la topologie de l'image de rendu.

7.  Le procédé d'alignement d'images de n'importe laquelle des revendications 5 et 6, dans lequel le sous-échantillonnage de l'image de rendu est réalisé en utilisant une fonction de floutage convexe.

8.  Le procédé d'alignement d'images de la revendication 7, dans lequel la fonction de floutage convexe comprend une fonction d'ellipse.

9.  Le procédé d'alignement d'images de n'importe laquelle des revendications 5 à 8, dans lequel le sous-échantillonnage de l'image de référence correspondante cause le floutage de l'image de rendu.

10. Le procédé d'alignement d'images de n'importe laquelle des revendications 1 à 9, dans lequel l'image de l'échantillon comprend une image de faisceau de particules chargées, une image optique, ou une image numérique.

11. Le procédé d'alignement d'images de n'importe laquelle des revendications 1 à 10, dans lequel les informations associées à l'image de référence correspondante comprennent des informations au format GDS (*Graphic Database System*)*,* au format GDS II (*Graphic Database System II*), ou au format OASIS (*Open Artwork System Interchange Standard*)*.*

12. Un système d'alignement d'images comprenant :

    une mémoire stockant un ensemble d'instructions ; et
    un processeur configuré pour exécuter l'ensemble d'instructions afin d'amener le système d'alignement d'images :

    à obtenir une image (310) d'un échantillon (250) ;
    à obtenir des informations (330) associées à une image de référence correspondante (440) ;
    à générer une image de rendu modifiée (450) par modification d'une image de rendu de l'image de référence correspondante de telle sorte qu'une topologie de l'image de rendu est substantiellement préservée ; et
    à aligner l'image de l'échantillon avec l'image de rendu modifiée.

**13.** Le système d'alignement d'images de la revendication 12, dans lequel l'ensemble d'instructions amène en sus le système d'alignement d'images à aligner l'image de l'échantillon avec l'image de référence correspondante sur la base d'un alignement entre l'image de l'échantillon et l'image de rendu modifiée.

**14.** Le système d'alignement d'images de n'importe laquelle des revendications 12 et 13, dans lequel l'ensemble d'instructions amène en sus le système d'alignement d'images à modifier l'image de rendu sur la base d'une caractéristique de la topologie de l'image de rendu, et dans lequel la caractéristique de la topologie comprend une taille, une forme, une orientation, ou une délimitation d'un trait, ou un espacement entre des traits adjacents de l'image de rendu.

**15.** Le système d'alignement d'images de la revendication 14, dans lequel l'ensemble d'instructions amène en sus le système d'alignement d'images à sous-échantillonner l'image de rendu sur la base d'une échelle de sous-échantillonnage, l'échelle de sous-échantillonnage étant basée sur la caractéristique de la topologie, et dans lequel le sous-échantillonnage est basé sur une valeur maximale de l'échelle de sous-échantillonnage qui préserve substantiellement la topologie de l'image de rendu.

100

**FIG. 1**

**FIG. 2**

Storage Module
320

Information file
330

Reference Image
340

Rendered Image
350

Electron Beam Tool
40

Inspection Image
310

Image Alignment Module
360

Image Aligner
364

Output Device
362

300

*FIG. 3*

FIG. 4A

*FIG. 4B*

500

Obtaining an inspection image 510

Obtaining information associated with a corresponding reference image 520

Rendering the corresponding reference image to form a rendered image 530

Modifying the rendered image to form a modified rendered image such that a topology of the rendered image is preserved 540

Aligning the inspection image with the modified rendered image 550

*FIG. 5*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018330511 A1
- US 2008298719 A1
- US 2007230770 A1
- US 2015086127 A1

**Non-patent literature cited in the description**

- **ALTUNBASAK Y et al.** A maximum a posteriori estimator for high resolution video reconstruction from MPEG video. *IMAGE PROCESSING, 2000, PROCEEDINGS IEEE*, 10 September 2000, 649-652

- **TAE HYUN KIM et al.** Dynamic Scene Deblurring using a Locally Adaptive Linear Blur Model. *ARXIV.ORG*, 14 March 2016